(19)

Europäisches
Patentamt
European
Patent Office
Office européen
des brevets

(11) **EP 2 592 178 A1**

(12) **EUROPEAN PATENT APPLICATION**
published in accordance with Art. 153(4) EPC

(43) Date of publication:
**15.05.2013 Bulletin 2013/20**

(21) Application number: **11803134.3**

(22) Date of filing: **30.06.2011**

(51) Int Cl.:
*C25F 3/12* (2006.01)          *H01L 21/3063* (2006.01)

(86) International application number:
**PCT/CN2011/076700**

(87) International publication number:
**WO 2012/003780 (12.01.2012 Gazette 2012/02)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **07.07.2010 CN 201010219037**

(71) Applicant: **Xiamen University
Xiamen,
Fujian 361005 (CN)**

(72) Inventors:
• **ZHAN, Dongping**
**Xiamen**
**Fujian 361005 (CN)**
• **SHI, Kang**
**Xiamen**
**Fujian 361005 (CN)**
• **TIAN, Zhongqun**
**Xiamen**
**Fujian 361005 (CN)**

• **ZHOU, Jianzhang**
**Xiamen**
**Fujian 361005 (CN)**
• **TIAN, Zhaowu**
**Xiamen**
**Fujian 361005 (CN)**
• **HAN, Lianhuan**
**Xiamen**
**Fujian 361005 (CN)**
• **TANG, Jing**
**Xiamen**
**Fujian 361005 (CN)**

(74) Representative: **Lambert, Ian Robert
Wynne-Jones, Lainé & James LLP
Essex Place
22 Rodney Road
Cheltenham
Gloucestershire GL50 1JJ (GB)**

(54) **PROCESSING METHOD FOR PHOTOCHEMICAL/ELECTROCHEMICAL PLANISHING-POLISHING IN NANO-PRECISION AND DEVICE THEREOF**

(57)    The present invention provides a nano-presion photo/electrochemical planarization and polishing method and an apparatus therefor. The method comprises through electrochemical, photochemical or photoelectrochemical means, an etchant being generated on a surface of a tool electrode which has a nanometer-sized planeness; the generated etchant reacting with a scavenger contained in an working electrolyte solution, or decaying itself in the working electrolyte solution, such that a confined etchant liquid layer is generated on the tool electrode surface and having a confined thickness of nanoscale; and by a chemical reaction between the etchant contained in the confined etchant liquid layer and a surface of a workpiece, the surface of the workpiece being polished or planarized to a nanometer scaled profile precision and surface roughness, thereby, realizing the planarization and polishing in nano-precision for the workpiece.

Fig. 3

## Description

### Technical Field

The present invention concerns a photo/electrochemical inducing planarization and polishing technology based on confined chemical etching, especially the planarization and polishing methods and apparatus based on confined chemical etching on the surfaces of metals, semiconductors or insulates for the large-area and mass production.

### State of the Art

Nowadays, in semiconductor industry, the feature linewidth of ultra-large scale integrate circuit (ULSI) has been down to 120 nm and the diameter of wafer has been up to 300 mm. Feature linewidth lower than 100 nm is coming into market. The number of transistors on a single chip has broken through $10^8$. According to the development blueprint of the Semiconductor Industry Association of USA, the feature linewidth of microelectronics will be down to 50 nm, the wafer diameter will be up to 450 mm by 2011, and the metal layers of ULSI will be developed from 5-6 toward larger than 5-6. At present, the International Semiconductor Industry Association considers that the globe planarization of the wafer has to be performed when the feature size is down to 350 nm or less in order to ensure the precision and resolution of lithography. Planarization and polishing will become a key technique and play a crucial role in the development of the ULSI manufacture.

The precondition of USLI manufacture is that a substrate such as silicon wafer has to subject to the planarization and polishing of the surface and then is used. With the feature size of a device decreasing down to nanometer size, the requirements of surface quality, especially the surface planeness and mechanical damage of the silicon wafer become higher and higher while the resolution and the focusing depth of lithography have more and more limitation. Thus, the wafer with large size surface should have a surface with a profile precision of nanometer and a surface roughness of sub-nanometer. Meantime, the wafer should have a surface and subsurface without stresses and damages. Furthermore, each layer has to be planarized globally during the construction of the multi-layer wiring of ULSI. With the development of ULSI in the miniaturization of feature linewidth, three-dimensional constructions and multi-layer wiring, RC delay affects the performance of devices. In order to eliminate the RC delay, multi-layer high frequency metal interconnection structures have to be constructed. During the construction, if any layer constructing the device is too high in surface roughness, the device will have an increasing noise and poor uniformity of the electrical property, which will reduce frequency characteristic of the device and thereby reduce the integrated level, reliability and high quality product of ULSI. Thus, each layer for the device must be globally planarized, i.e., it is required to provide the removement and planarization of the excess deposition of copper (Cu) interconnectors of multiple wirings and of the dielectric layer such as $SiO_2$, SiOF and other layer with superlow k having concavo and convex, which is a key step to achieve three dimensional structure of the ULSI. Moreover, as the feature size is further down, the adverse effect caused by diffusion of metal Cu into the $SiO_2$ insulating layer will tend to be severe. It is an efficient way to provide a diffusion barrier layer or a porous delectric material with superlow k (insulator) in order to solve above technical problem. Moreover, Ta or TaN are considered a desirable metal material for the barrier layer due to their excellent adhesiveness to Cu and thermostability. However, the deposition of Ta or TaN onto the microcircuit board is non-selective. That means the insulator $SiO_2$ layer will be covered totally. Thus, the unwanted Ta or TaN depositions have to be removed out of the Cu wire casing. Since Ta is a hard metal and is harder when oxidized, how to remove and planarize the unwanted Ta or TaN depositions will be another key technique for the globe planarization for the future ULSI manufacture. Moreover, how to planarize the fragile or flexible porous low-k dielectric material still remains great challenge. In summary, developing a multifunctional planarization and polishing method in nano-precision applied to metal, semiconductor and insulator at the same time is a common and key technique for the industrial manufacture of ULSI, which is recognized by all the countries all over the world.

Currently, chemical mechanical polishing (CMP) is the most effective technology and the only way to achieve the submicron size global planarization. CMP is a process of smoothing surfaces with the combination of chemical and mechanical forces, i.e., the oxidizers, catalysts and the like existed in the polishing slurry react with the surface atoms of the workpiece to form an oxide film on the workpiece surface, which is removed through mechanical friction by the abrasive grains suspended in the polishing slurry; the resulted fresh surface of the workpiece continues to be oxidized; thus, with the alternative oxidization and polishing, the workpiece surface is polished and planarized. However, due to the nonuniformity of mechanical friction and external force, the roughness after polishing still remains high, which will affect directly on the subsequent processes and also the finished product ratio. The most frequently used abrasive grains, e.g., $Al_2O_3$ particles, are hard and dispersed in the viscous slurry, which is easy to cause surface damages, even deep surface damages. Furthermore, there exist many other problems such as metal ion contaminations to workpiece surface, poor dispersion of abrasive grains in the slurry, and low removal rate in alkaline environment. During application of the CPM technology, another important issue is to determine and control the end points for the planishing-polishing method, i.e. it is difficult to determine when the desired amount of material has been removed or the desired degree of planarization has been obtained. If the oxide layer has been overly thinned and/or the desired degree of planarity has not been obtained during this process, the sequence process would be further done. More importantly, the future ULSI manufacture requires the wafer of having a profile precision of nanometer and a surface roughness of sub-nanometer, which is beyond the limit of CMP (in a 20 mm × 20 mm area Ra < 20 nm). Although, in recent years, assistant means of electrochemistry has be applied to CMP, where anodic dissolution is employed so as to improve the effects on polishing and planarization of copper or other semiconductor material. Unfortunately, the above mentioned disadvantages for CMP are not completely eliminated.

On the other hand, there are two development tendencies for the manufacture of modem precision optical devices: the micro-optical elements (MOC) and large dimensional ultra-precise optical devices. MOC is the optical element constructed by freeform optical surface with microstructure which has a profile precision of micrometer and a surface roughness of sub-nanometer, typically it includes the holographic lens, diffractive optical elements, GRIN-rod lens and so forth. With the tendency of miniaturization, MOC has prospective application into the science and technology of both national defense and civil industrial domains. Large dimensional ultra-precise optical devices are also important. For example, it may use as the huge lens and reflecting mirrors of space telescopes and the large dimensional high precise optical glass elements in laser fusion devices, which should have a surface roughness Ra of less than 1 nm in the high-frequency section. The polishing method for the ultra-precision optical devices is also dependent on CMP. Thus, it is necessary to develop a new planarization and polishing method which may avoid the disadvantages of CMP and, at meantime time, may achieve a profile precision of nanometer and a surface roughness of sub-nanometer.

The applicants, in their Chinese patent ZL03101271.X, disclose a fabrication method and its apparatus for 3D complex microstructures on metal surface. The method comprises: fixing a molded tool electrode with micro structure on a fixing mount; pouring the working electrolyte solution into an electrochemical cell; immersing the molded tool electrode into the working electrolyte solution; starting an electrochemical workstation to produce etchant on the surface of the molded tool electrode; confining a layer of the etchant into a micro/nano-meter thickness through a scavenger existed in the electrolyte solution; starting a manipulator to carry out a etching process for a workpiece by an etchant layer such that material of a surface of the workpiece is removed and separated from the etchant layer until the etching process is completed. The manufacturing apparatus includes a molded tool electrode, a fixed mount, a manipulator, an electrochemical workstation, and a computer control system. This method and its apparatus disclosed in the Chinese patent ZL03101271.X can perform the mass production of the duplication of various 3D complex microstructures. It is a one-step forming technique without coating, exposing, developing and decoating. Consequently, the cost is lowered and the precision as well as the planarization are promoted dramatically. Since this technique is indeed distance sensitive, the removal amount for the workpiece can be well controlled by accurately controlling feeding distance of a template.

**Disclosure of the invention**

The first object of the present invention is to provide a photo/electrochemically-induced confined chemical etching method for the surface planarization and polishing in profile precision and surface roughness of nanometer scale. This method comprises the following steps: generating an etchant on the surface of a tool electrode having a nanometer-sized planeness through electrochemical, photochemical or photoelectrochemical means; the generated etchant reacting with a scavenger contained in a working electrolyte solution, or the etchant itself decaying such that an etchant liquid layer with a thickness of nanometer-scale is produced on the surface of the tool electrode; and the etchant in the etchant liquid layer reacting with a workpiece such that the surface of the workpiece is provided with nanometer-scale profile precision and roughness, so as to realize planishing and polishing in nano-precision for the workpiece.

The another object of the present invention is to provide an apparatus for the photo/electrochemically-induced confined chemical etching method for the surface planarization and polishing in profile precision and surface roughness of nanometer scale. The apparatus includes a tool electrode, a photo/electrochemical reaction control system, an optic control system, a working electrolyte solution recycling system, a working electrolyte solution temperature controlled system, and an automated computer-controlled system.

The tool electrode is a tool electrode having a planeness of nanometer-scale;

The photo/electrochemical reaction control system includes: a potentiostat, an optic control system, a photo/electrochemical working electrode, an auxiliary electrode, a reference electrode, a working electrolyte solution and a container. The tool electrode functions as the photo/electrochemical working electrode and connects with the potentiostat and/or the optic control system. The photo/electrochemical working electrode, the auxiliary electrode and reference electrode are immersed in the container which contains the working electrolyte solution and also contains the workpiece.

The working electrolyte solution recycling system is used to recycle the working electrolyte solution in the photo/electrochemical reaction control system;

The working electrolyte solution temperature controlled system is used to make the working electrolyte solution in the photo/electrochemical reaction control system at constant temperature;

The automated computer-controlled system includes: a fixed mount, a multi-dimension ($\geq$ 3D) micro-manipulator, a video monitor, a force sensor, a parallel laser ranging device, an electrical current feedback device and an information processing computer. The lower part of the fixed mount functions to fix the tool electrode, and the upper part of the fixed mount functions to connect with the Z-axial micro motor of the multi-dimension micro-manipulator in the automated computer-controlled system, wherein the Z-axial micro motor connects with the information processing computer. The container is provided on the X-Y-axial micro motors of the multi-dimension micro manipulator. The video monitor is used to monitor the approaching process of the tool electrode to the workpiece. The electrical current feedback device is used to monitor or measure the electrical current flowing through the surface of the tool electrode. The force sensor is used to detect whether the tool electrode touches the workpiece or not. The parallel laser ranging device is used to detect the distance between the tool electrode and the workpiece. According to the collected parameters such as the feedback current provided by the electrical current feedback device, the contact force provided by the force sensor, and the distance between the two surfaces provide by the parallel laser ranging device, the information processing computer send commands to the Z-axial micro motor and the X-Y-axial micro motors of the multi-dimension micro manipulator to adjust the distance and parallelity between the tool electrode surface and the workpiece surface.

The working electrolyte solution contains precursors of the etchant and/or leveling agent. The precursors of the etchant and/or leveling agent can generate the etchant and leveling agents on the surface of the tool electrode through photo/electrochemical reaction. If the generated etchant and leveling agents cannot decay spontaneously, the electrolyte solution further contains scavengers which can confine the etchant liquid layer on the tool electrode surface to a namometer-scaled thickness.

The polishing and planishing method and apparatus disclosed by the present invention can realize a nanometer-scaled profile precision and surface roughness (i.e. nano-precision) on the surface of the workpiece. Comparing to CMP, the distinct advantages of the present invention lie in that: there is no surface and sub-surface mechanical damages for a workpiece; there is no residual stress; and the endpoint of polishing and planarization is easily controllable.

**Description of Figure**

Figure 1 is schematic diagram of an example of the apparatus of the present invention for the photo/electrochemically-induced confined chemical etching method for a surface planarization and polishing in nano-precision.

Figure 2 is schematic diagram of another example of the apparatus of the present invention for the photo/electrochemically-induced confined chemical etching method for a surface planarization and polishing in nano-precision.

Figure 3 is schematic flow chart of the photo/electrochemically-induced confined chemical etching method for a surface planarization and polishing in nano-precision according to the present invention.

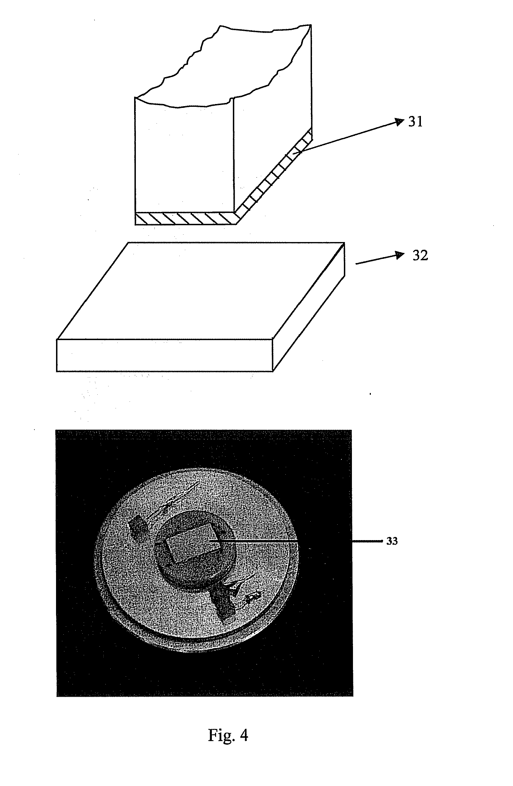

Figure 4 is the schematic diagrams of a nano-planeness planar tool electrode and its technical process for polishing and planishing the surface of a workpiece used in the present invention wherein it is described that the tool electrode having a large size in X-Y dimensions approaches the workpiece. During polishing and planarization, the workbench is rotating while the tool electrode or the workpiece is swaying on the plane of workbench. Through the relative movement between the tool electrode and the workpiece, the profile precision on the surface of the workpiece is further improved and the surface roughness is lowered.

Figure 5 is the schematic diagrams of a nano-planeness linear tool electrode and its technical process used in the present invention. The linear tool electrode has a larger size in X dimension but smaller size in Y dimension, and the tool electrode or the workpiece is subjected to a relative movement (translation movement or rotary motion) in X-Y direction to realize the large-area polishing and planarization of a plane surface in mass production.

Figure 6 is the schematic diagrams of a nano-planeness linear tool electrode and its technical process used in the present invention. The tool electrode has a larger size in X dimensions but smaller size in Y dimension. The tool electrode approaches to a rotating workpiece to realize the large-area polishing and planarization of a cylindrical surface.

Figure 7 is the schematic diagram of a milling cutter like tool electrode with nano-planeness, which moves according to a programmed track to perform large-area polishing and planarization of an irregular surface.

Figure 8 is the SEM images of a copper (Cu) surface before (a) and after (b) polishing and planarization according to example 1 of the present invention.

Figure 9 is the SEM images of a silicon (Si) surface before (a) and after (b) polishing and planarization according to example 2 of the present invention.

Figure 10 is the SEM images of gallium arsenic (GaAs) surface before (a) and after (b) polishing and planarization according to example 3 of the present invention.

Figure 11 is the SEM images of a $SiO_2$ glass surface before (a) and after (b) polishing and planarization according to example 4 of the present invention.

## Embodiments for carrying out the invention

### Definitions

In the present invention, the term "photo/electrochemical" includes photochemical, electrochemical and/or photoelectrochemical means which are employed to produce etchant at a surface of the tool electrode.

In the present invention, the terms "etchant" or "etchant and/or leveling agent" refer to chemicals which can react with and etch the surface of the workpiece, or catalysts which can promote the etching and polishing rate of the etchant and/or leveling agent contained in the working electrolyte solution. The terms "precursors of the etchant" refer to materials which can produce an etchant through inducing of the photo/electrochemical reaction.

In the present invention, the term "confined etchant layer" refers to a liquid layer with a nanometer-sized thickness containing etchant and/or leveling agent which is generated through photo/electrochemical means and compacted by the scavengers in the working electrolyte solution. In general, the thickness of confined etchant layer is controlled no more than 100 nm. In the more accurate polishing and planarization process, it can be controlled less than 20 nm. The term "confined" means the thickness of the etchant liquid layer always keeps a thickness at nanometer scale during the processes of polishing and planarization of the workpiece.

In the present invention, the term "scavenger" is the chemical in the working electrolyte solution which can react with the etchant and/or leveling agent produced on the surface of the tool electrode and, consequently, compact the etchant liquid layer into a thickness of nanometer scale.

In the present invention, the terms "confined etching system" and "working electrolyte solution" refer to the solution system containing a precursors of etchant, a scavenger and optionally, a surfactant, a supporting electrolyte, a pH buffer, and the like according to special object to be etched, or, the solution system containing a precursors of etchant, and optionally, a surfactant, a supporting electrolyte, a pH a buffer, and the like according to special object to be etched. The term "mass balance of the confined etching system" means to keep a ratio of the components of the confined etching system in a reasonable range.

The present invention provides a photo/electrochemically-induced chemical etching method for surface planarization and polishing in a nanometer scale precision, characterized by use of the confined etchant layer technique (CELT). That is, through the photo/electrochemical means, a confined etchant and/or leveling agent layer having a thickness of nanometer scale is formed on the surface of the tool electrode with nano-planeness; the etchant reacts with and remove a workpiece material until the profile precision and surface roughness of the workpiece surface reach a precision of nanometer scale; thereby the workpiece achieves the desirable polishing and planishing treatment. The basic principle of CELT is described as followed:

(1) Through the electrochemical, photochemical or photoelectrochemical means, i.e. the suitable parameters such as potential or/and light wavelength and intensity is choosed based on chemical characteristics of the confined etching system, the precursors of etchant will be reacted to form etchant on the surface of tool electrode through the photo/electrochemical means. The etchant can be either a conventional chemicals or chemical radicals. The etchant generation reaction presented on the surface of the tool electrode can be expressed as:

$$R \rightarrow O + ne \text{ or } R + h\nu \rightarrow O \ (+ ne) \qquad (1)$$

where, R is the precursor of etchant and O is the generated etchant.

(2) The scavenger contained in the working electrolyte solution will react with the etchant in the vicinity of tool electrode surface to compact the etchant layer to a thickness of nanometer scale. If the generated etchant is a chemical radical, the thickness of the etchant layer can be compact through either the scavenger or spontaneous decay of the radical itself. The scavenging reaction can be expressed as:

$$O + S \rightarrow R + Y \text{ or } O \rightarrow Y \qquad (2)$$

where, S is the scavenger and Y is product by a reaction between the etchant O and the scavenger or by the decay of the etchant O itself. The thickness of confined etchant layer depends on the reaction rate of reaction (1) and (2), and the concentration ratio of between the etchant precursor and the scavenger. If the concentration of the scavenger is pretty higher than that of the etchant precursor, a limited thickness of the confined etchant layer can be estimated by the following equation:

$$\mu = (k_2 / D_R)^{1/2} \qquad (3)$$

where, $k_2$ is the quasi-first order reaction rate of scavenging reaction (2), $D_R$ is diffusion coefficient of etchant precursor in the working electrolyte solution. In the practical etching process, the thickness of confined etchant layer can be adjusted by changing the concentration ratio of between the etchant precursor and the scavenger, i.e., the precision of polishing and polarization can be tunable. Although the thickness of a confined etchant layer is at nanometer scale, the concentration distribution of etchant keeps constant inside the confined etchant layer.

(3) Through the automated computer-controlled system, let the confined etchant layer contacts with the workpiece and start the process of polishing and planarization for the workpiece. The etching reaction can be expressed as:

$$O + M \rightarrow R+P \qquad (3)$$

where, M is the material of workpiece, and P is the product of a reaction between the workpiece and the etchant. The removal rate of the workpiece surface is determined by a rate of the etching reaction (3). Once the surface parts of workpiece contacting with the confined etchant layer are removed, the workpiece will separate from the confined etchant layer. Consequently, the polishing and planarization process stops. Then, the automated computer-controlled system will feed the tool electrode and continue the etching process until the workpiece is well polished and planarized.

Concretely, the photo/electrochemically-induced, chemical etching method for surface planarization and polishing in a nanometer scale precision described in the present invention includes the following steps:

(1) Fabricating a tool electrodes with nano-precision planeness surface as the working electrode for the photo/electrochemical reaction to produce an etchant through photo/electrochemical means;

(2) Fixing the tool electrode with nano-precision planeness surface on a fixed mount and a workpiece in the bottom of a container; or fixing the workpiece on a fixed mount (or the workbench), and fixing the tool electrode with nano-precision planeness surface in the bottom of a container;

(3) Pouring a working electrolyte solution into the container, which containing the etchant precursor, a scavenger, a solvent and at least one selected from the group consisting of a surfactant, a supporting electrolyte, a pH buffer and so on;

(4) Immersing the tool electrode (or the workpiece) into the working electrolyte solution as the working electrode for the photo/electrochemical reaction. In the container, the reference and auxiliary electrodes are also implanted. The photo/electrochemical reaction system starts and produces an etchant on the surface of tool electrode. The produced etchant reacts with the scavenger, or spontaneously decays if the etchant is free radical, and forms the confined etchant layer with a thickness of nanometer scale on the surface of tool electrode;

(5) Through the multi-dimension micro-manipulator driven by the automated computer-controlled system, feeding the tool electrode (or workpiece) and approaching it to the workpiece (the tool electrode); adjusting the distance and parallelity between the tool electrode surface and the workpiece with the help of in-situ observation from the video monitor and parallel laser ranging device. Furthermore, through controlling the distance between the tool electrode and the workpiece less than the thickness of the etchant layer or/and the relative motion (comprising translation movement and rotary movement) between the tool electrode and the workpiece to improve the mass balance of the working electrolyte solution. In this way, the uniformity of polishing and planarization is promoted, i.e., the profile precision of the working piece surface is improved and the surface roughness of the working piece surface is lowered;

(6) Feeding the tool electrode (or the workpiece) in vertical direction to the workpiece (or the tool electrode) such that the confined etchant layer on the tool electrolyte surface contacts with the workpiece surface, and thereby keeps the etching process advance. Also, the tool electrode or workpiece to be processed is fed in X-Y dimensions until the whole surface of workpiece to be processed is well polished and planarized.

In the step (4), the thickness of the confined etchant liquid layer can be tuned through controlling the potential of a tool electrode, a wavelength and intensity of a light-wave, and a formulation, temperature and recycle of the working electrolyte solution. The described confined etchant layer can be controlled at a thickness of 100 nm or less, preferably less than 20 nm. In practice, an amount of etchant is controlled by selection of the parameters such as the limiting diffusion potential of the generation reaction of the etchant as well as the wavelength and intensity of the excised light, and the selection of these parameters directly affect on the thickness of confined etchant layer, and the removal rate of the workpiece surface. The described "limiting diffusion potential" means under this potential the photo/electrochemical current keeps a constant maximum. For example, when etching Si under acidic condition, the "limiting diffusion potential" for oxidizing a bromide ion ($Br^-$) to an etchant bromine ($Br_2$) should be 0.9 V or more. The term "surface removal rate" refers the removal mass of workpiece surface material in a unit time by the chemical etching (g/min), or the removal thickness of the workpiece surface in a unit time ($\mu$m/min). For example, in the case of etching GaAs by $Br_2$, the surface removal rate can be achieved 0.2 $\mu$m/min.

In the step (5), the distance and parallelity between the tool electrode and the workpiece can be controlled based on the feedback parameters provided by the current feedback deveice, the force sensor and the parallel laser ranging device.

The tool electrode (a working electrode in the photo/electrochemical system) used in the present invention has a nanometer-precise surface planeness, which can be planar and have a large size in X-Y dimensions, or be linear and have a large size in one dimension. The tool electrode may be fabricated by the method for preparing the tool electrode having a nanometer-precise surface planeness in the prior art, or may be fabricated by some new methods provided by the present inventor for preparing the tool electrode having a nanometer-precise surface planeness. These methods are listed as followed:

(1) Fabricating a tool electrode with nano-planeness of platinum, gold, iridium, tungsten or other metal though the ultra-precision machining (e.g., nano-cutting).
(2) Depositing a metal or semiconductor on a substrate with an atomic planeness through various processes for forming film (such as electron beam evaporation, magnetron sputtering, electroplating and chemical plating), or growing a metal or semiconductor on the substrate through crystal epitaxial growth technology to make the substrate conductive.
(3) Fabricating a single-crystal tool electrode having a surface of nano-planeness formed of platinum, gold, iridium or other metal through accurate cooling or drawing of the corresponding melt metal;
(4) Fabricating a electrode surface having a nanometer-planeness by polishing and planarizing polycrystal or single crystal metal electrodes through CMP technology together with an electrolytic process;
(5) Using a nanometer planeness surface formed by liquid metal or alloy spontaneously; and
(6) A process for photocatalytical or photoelectrocatalytial tool electrode, that is, the insulating quartz optical material or conductive ITO or FTO optical glass is used as a substrate, and is covered with a layer of $TiO_2$, $ZnO$, $WO_3$, $Fe_2O_3$, $CdSe$ or the composite photocatalysts thereof through surface modification, electrochemical deposition in situ or chemical vapor deposition.

During the polishing and planarization process, the species produced in the vicinity of tool electrode surface through photo/electrochemical means may be either the etchant and leveling agent which can directly react with the material of workpiece surface, or be one of catalysts which can accelerate the chemical etching rate of the etchant and leveling agent contained in the electrolyte solution, or the both.

In the photo/electrochemically-induced confined chemical etching method for surface planarization and polishing in nanometer scale precision according to the present invention, the etchant and leveling agent can be widely chosen according to different workpieces. In general, etchants are determined by the material of workpiece, and suitable precursors of etchants and corresponding scavengers are determined by the etchants. Moreover, the selected precursors of the etchant and leveling agent and the selected scavengers are added to the working electrolyte solution, respectively.

The workpiece to be processed in the present invention can be a workpiese formed of metals (e.g., Cu in the USLI board), semiconductors (e.g., Si substrate), or insulators (e.g., $SiO_2$ glass). Furthermore, the present invention can realize polishing and planarization in nano-precision of the surface of metals, semiconductors or insulators in mass production.

For example, when the workpieces to be processed are metals, the concentration of strong acids such as $HNO_3$, $H_2SO_4$ and the like contained in the confined etchant layer is increased by a control of pH of the confined etchant layer, and thereby the metal is reacted with the acid to form soluble salts; or an etchant with strong oxidizability such as oxygen, fluorine, chlorine, bromine, ferrocene, iron cyanides, metal complex and the like is generated and can directly react with the objective metal to form soluble salt; or a strong oxidant such as hydrogen peroxide, oxygen, ozone, oxygen-containing radicals is generated and can react with the metal surface to form oxide, then, the formed oxide can be dissolved and removed by acid material contained in the electrolyte solution such as sulfuric acid, nitric acid, hydrochloric acid, oxalic acid and the like. The examples of the used scavengers are compounds containing disulfide bond such as cystine and the like, ferrocene and its derivatives, persulfates, nitrites, sulfites, thiosulfates, ascorbic acid, sorbitol, and mixtures thereof. In order to improve the solubility of metal ions in the working electrolyte solution, additives or surfactants may be added to the working electrolyte solution and complex with the metal cations. The examples of the additives and surfactants include halide ions, ammonia, cyanide ion, thiocyanide ion, crownether based supermolecular compounds, sodium alkylsulfonate, polyethers (preferably oxyethylene), nitrogen-containing azole based compound and so forth.

For example, when the objective workpieces are semiconductors such as Si, Ge, GaAs, or transition metals and their binary/ternary alloys thereof, or insulators such as quartz, glass, sapphire, MgO, TeCdHg, and $KH_2PO_4$, the strong oxidants such as oxygen, fluorine, chlorine, bromine, permanganate ion, bichromate ion, perchlorate ion, nitrate ion, or oxygen-containing free radicals are generated in the confined etchant layer, and meanwhile, complexing agents such as halide ions, ammonia, cyanide ion, thiocyanide ion, crownether based supermolecular compounds, sodium alkylsulfonate, polyethers (preferably polyoxyethylene), or nitrogen-containg azole based compound are added to the working electrolyte solution to improve the solubility of etching products and thereby achieve the object of polishing and planishing surface of the workpiece. The used scavengers are the reductive compounds such as cystine and the other compounds containing disulfide bond, ferrocene and its derivatives, persulfates, nitrites, sulfite, thiosulfates, ascorbic acid, sorbitol, or mixtures thereof. The used solvent may be water, acetonitrile, tetrahydrofuran, dimethylsulfoxide, N, N'-dimethylformamide, and ionic liquids including quarternary ammonium ion, quarternary phosphorus ion, imidazolium ion, or pyrrolium ion as a cation.

Moreover, as described above, the thickness of the confined etchant layer according to the present invention also depends on concentration ratio of etchant over scavenger. In general, the ratio is from 10:1 to 1:100, preferable 1: 1 to 1:20. For example, when at least one selected from the group consisting of ferrocene and its derivatives, persulfate, dissolved oxygen, bromide, fluoride, and alkylamine is used as etchant precursor, the concentration of etchant precursor is usually controlled in a range from 0.001 to 1.0 mol/dm$^3$. The etchant precursors generate etchants and/or leveling agents which can etch the surface of the workpiece through electrochemical reaction, and the generated etchants and/or leveling agents may rapidly react with at least scavenger selected from the group consisting of disulfide bond compounds, ferrocene and its derivatives, persulfates, nitrites, sulfites and thiosulfates. Consequently, the lifetime of the etchant and/or leveling agent will be shortened due to the fast scavenging reaction. Since their lifetime is very short, the etchant and/or leveling agents can't diffuse too far away from the tool electrode surface and would form a confined etchant liquid layer having a thickness of nanometer scale. That means the polishing and planarization can be processed with an extremely high resolution. Moreover, due to the existence of confined etchant liquid layer between the tool electrode and the workpiece, the tool electrode does not actually contact the surface of the workpiece and thereby keeps its surface retaining the nano-precise planeness.

When the etchant precursors used in the present invention are at least one selected from the group consisting of dissolved oxygen, ozone, peroxides, superoxides, oxynitrides, hypochlorites, nitrites, persulfates and alkyl peroxides, the concentrations of the etchant precursors are in range of from 0.001 to 1.0 mol/dm$^3$. The free radical etchant is produced through photo/electrochemical reaction on the surface of tool electrode and etches the workpiece surface. Since the free radicals etchant in these cases are chemical radicals with very short lifetime, they only diffuse in the solution in very short diffusion distance from the surface of tool electrode. Thus, a confined etchant liquid layer having a thickness of nanometer scale may be formed on the surface of tool electrode. Thus, a chemical etching on the surface of the workpiece may be performed at extremely high resolution.

Moreover, due to the existence of confined etchant liquid layer between the tool electrode and the workpiece, the tool electrode does not actually contact the surface of the workpiece and thereby keeps its surface retaining the nano-precise planeness.

According, it can be concluded that the formulation of the working electrolyte solution used in the present invention meets the following requirements:

(1) The working electrolyte solution contains precursors of the etchants and/or leveling agents. The etchants and leveling agents can be produced through photo/electrochemical reaction and etch the workpiece surface. The reaction rate is sufficiently high, and the etching rate is not less than 10 nm/min.
(2) The chemical etching reaction between the etchant and the workpiece should be isotropic.
(3) There should be no indissolvable or poor dissolubility compounds formed during the process of polishing and planarization.
(4) The scavengers (confining agents) can react fast with the etchants and/or leveling agents and confine the etchant and/or leveling agent layer in a thickness of nanometer scale.
(5) The whole solution system should be stable.

Comparing to CMP, prominent advantages of the present invention are listed as followed:

(1) Since the tool electrode doesn't contact with the workpiece, there are no surface and subsurface mechanical damages and no residual stress on the workpiece surface.
(2) Since there are no other metal ions formed during the polishing and planarization process, which are easily precipitated, the metal ions contaminations can be avoided.
(3) Since the occurrence of a chemical etching and/or leveling reaction depends on whether the confined etchant liquid layer contacts with the workpiece surface or not, the polishing and planarization is typically a self-ended process. That means, with the chemical etching and/or leveling reaction going on, the surface material of workpiece is gradually dissolved and finally separates from the confined etchant layer. Then, the chemical etching reaction is stopped. Therefore, the end-point of polishing and planarization process is controllable.

The second object of the present invention is to provide an apparatus for the photo/electrochemically-induced

confined chemical etching method which provides a workpiece with profile precision and surface roughness of nanometer scale. The apparatus includes a tool electrode, a photo/electrochemical reaction control system, a working electrolyte solution recycling system, a working electrolyte solution temperature control system, and an automated computer-controlled system.

The tool electrodes have a nano-precise planeness. The materials of the tool electrodes can be metals such as platinum, gold, iridium, tungsten, titanium and the like, and alloys thereof; or semiconductors such as $TiO_2$, ZnO, $WO_3$, $Fe_2O_3$, CdSe, and the like, and photocatalytic composites thereof; or non-metal materials such as glass carbon, high temperature pyrolysis graphite, boron doped diamond and so on.

There are no special limitation on the shape of tool electrode, which can be a milling cutter like shape, a linear scraper like shape, a planar disk like shape or a groove based on the principle of hydrodynamic design. However, reasonable designs of the shape of the tool electrode, relative motion between the tool electrode and the workpiece and feeding means of the tool electrode are selected such that the processed shape of the workpiece may be plane, cylinder, cone, sphere, and non-sphere. In this way, the profile precision of workpiece is improved, and the surface roughness of workpiece is lowered. For example, in the case of a disk tool electrode, the profile precision can be improved and the surface roughness can be lowered by means of keeping the tool electrode or workpiece rotating while lateral swing in a plane.

The photo/electrochemical reaction control system can precisely control the thickness of the etchant and/or leveling agent layer at nanometer scale. In general, the thickness of the confined etchant layer can be controlled no more than 100 nm. In the more precise process of polishing and planarization, the thickness of the confined etchant layer can be controlled no more than 20 nm. Herein, the photo/electrochemical reaction system includes: a potentiostat or/and an optic control system, a photo/electrochemical working electrode, an auxiliary electrode, a reference electrode, a working electrolyte solution and a container.

The working electrolyte solution recycling system includes a circulating pump, a flow controller and a fluid bath.

The working electrolyte solution temperature controlled system includes a thermoscope, a heater, a cooler and a fluid bath.

The automated computer-controlled system includes: a fixed mount, a multi-dimension ($\geq$ 3D) micro manipulator, a video monitor, a force sensor, a parallel laser ranging device, an electric current feedback device and an information processing computer.

The tool electrode is fixed on the lower part of the fixed mount. The upper part of the fixed mount is connected with the Z-axial micro motor of the multi-dimension micro-manipulator in the automated computer-controlled system, wherein the Z-axial micro motor is controlled by the information processing computer. The tool electrode functions as the photo/electrochemical working electrode, which is connected with potentiostat and/or optical control system via the fixed mount. The auxiliary and reference electrodes are implanted into the working electrolyte solution in the container. The working electrolyte solution is heated to a constant temperature by the working electrolyte solution temperature controlled system, then pumped into the container, and circulated between the container and the fluid bath at constant temperature by the working electrolyte solution recycling system. The container is provided on the X-Y-axis micro motors of the multi-dimension micro-manipulator. The workpiece is placed in the container. The video monitor is used to control the procedure of the tool electrode approaching to the workpiece. The electrical current feedback device is used to detect the electrical current flowing through the surface of tool electrode. The force sensor is used to detect whether the tool electrode contacts with the workpiece or not. The parallel laser ranging device is used to detect the distance between the tool electrode surface and the workpiece surface. According to the collected parameters (such as a feedback electrical current provided by the electrical current feedback device, a contact force provided by the force sensor, and a distance between the two surfaces provided by the parallel laser ranging device), the information processing computer will send commands to the Z-axial micro motor and X,Y-axis micro motors of the multi-dimension micro-manipulator to adjust the distance and parallelity between the tool electrode surface and the workpiece surface. At the meantime, the multi-dimension micro-manipulator is also used to control the feeding means of tool electrode, and the relative motion means between the tool electrode and the workpiece.

The working electrolyte solution contains precursor of an etchant and leveling agent or/and a scavenger and a solvent, and optionally, a surfactant, a supporting electrolyte, a pH buffer and so on.

The solvent may be water, organic solvents, or ionic liquids. The organic solvent may be at least one selected form the group consisting of acetonitrile($CH_3CN$), dimethyl sulphoxide (DMSO), N,N'-dimethylformamide (DMF) and so on, and mixtures thereof. The ionic liquids include quarternary ammonium ion, quarternary phosphorus ion, imidazolium ion, pyrrolium ion or the like as a cation. The additives contained in the ionic liquids may be at least one selected from the group consisting of urea, acetamide, thiourea, trichloroacetic acid, phenylacetic acid, malonic acid, oxalic acid, *p*-toluene sulfonic acid, *m*-cresol, p-cresol, o-cresol, (-)fructose, and the like, and mixtures thereof. The additives have a concentration in a range of from 5% to 95% by mass based on the total mass of the working electrolyte solution.

The precursor of the etchant and/or leveling agent used in the present invention may be at least one selected from the group consisting of ferrocene and its derivates, persulphate, dissolved oxygen, bromide, fluid, alkyl amine compound and the like. In general, the precursor of the etchant and/or leveling agent has a concentration in a range of from 0.001 to 1.0 mol/dm$^3$, preferably from 0.01 to 0.1 mol/dm$^3$. The scavenger may be at least one selected from the group consisting of mercapto compound, ferrocene and its derivatives, persulfates, nitrites, sulfites, thiosulfates, and the like, and has a concentration in a range of from 0.05 to 10.0 mol/dm$^3$, preferably 0.1~1.0 mol/dm$^3$. The surfactant may be at least one selected form the group consisting of alkylsulfonate, quarternary ammonium salts, polyethers, benzotriazole compound and the like. In general, the surfactant has a concentration in a range of from 0.001 to 1.0 mol/dm$^3$, preferably 0.01~0.1 mol/dm$^3$.

The supporting electrolytes used in the working electrolyte solution function to ensure conductivity of the working electrolyte solution. The concentration of the supporting electrolyte is varied depending on the concrete material of the workpiece to be processed, and is usually 0.01 to 1 mol/L. A pH buffer added in the working electrolyte solution may be either acid or alkali.

The micro manipulator, the information processing computer, and the electrochemical reaction control system used in the apparatus for the photo/electrochemically-induced confined chemical etching method which provides a workpiece with profile precision and surface roughness of nanometer scale according to the present invention have been explained in the former Chinese patent ZL03101271.X of the present applicant, respectively. Based on the mentioned former patent, the micro manipulator extends from 3-dimentions to multi-dimensions ($\geq$ 3D), which is suitable for the polishing and planarization of complex surface types. Meantime, an optical control system is added in the apparatus of the present invention so as to modulate the process of polishing and planarization in photo- and electrochemical means. Since a confined etchant layer technique is adopted and a thickness of the confined etchant layer formed by photo/electrochemical reaction on the surface of tool electrode is at nanometer scale, the parallelity between the tool electrode and the workpiece is very crucial, especially, in the process of polilshing and planishing a workpiece with large area. In the former patent, a force sensor is adopted to adjust the distance between the tool electrode and the workpiece. In the present invention, a parallel laser ranging device is further incorporated into the apparatus of the present invention so as to adjust the distance and parallelity between the tool electrode and the workpiece together with the force sensor. In addition, the automated control system is incorporated into the apparatus of the present invention for fine tuning the multi-dimensional micro-manipulator, and, for feeding the tool electrode toward the workpiece until the confined etchant layer contacts the surface of workpiece to start the etching process through the feedback information from the current feedback device, the force sensor and the parallel laser ranging device. With the etching and leveling process going on, the surface material of workpiece is gradually dissolved and removed, and the automated control system keeps feeding the tool electrode through the multi-dimensional micro manipulator until the polishing and planarization well-done. The polishing and planarization process may be monitored through the video monitor. In order to ensure complement of scavenger and the mass balance during the polishing and planarization process, and in order to adjust etching reaction rate, the working electrolyte solution recycling system and the temperature control system are added in the present invention.

There is no mechanical stress, surface and subsurface damage, and metal ion contamination on the workpiece surface during the polishing and planarization process. The processing end-point of the polishing and planarization process is very easily controlled. Meanwhile, the method according to the present invention may apply to the mass production of large scale surfaces of various materials such as metals, semiconductors and insulators.

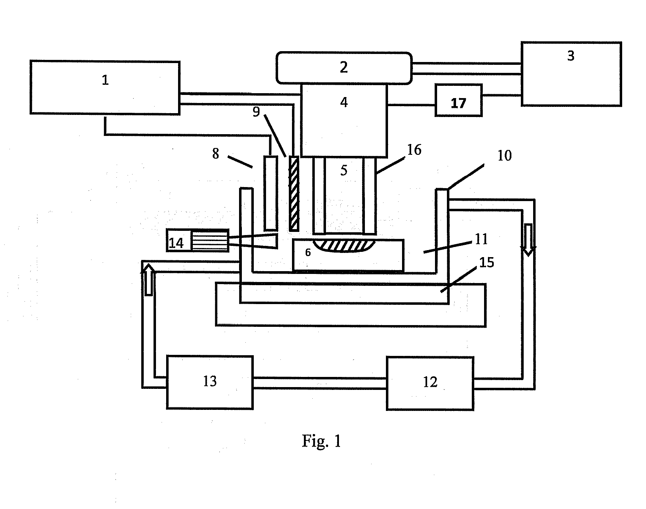

Figure 1 shows a schematic diagram of an example of the apparatus for performing the photo/electrochemically induced, confined chemical etching method for nano-precise polishing and planarization according to the present invention. The tool electrode 5 is a disk platinum electrode with a surface planeness of nanometer precision. The tool electrode 5 is fixed on the lower part of the fixed mount 4. The fiber optical probe 16 of the parallel laser ranging device 17 fixed on the outside of the tool electrode 5 is also fixed on the lower part of the metal fixed mount 4. The parallel laser ranging device 17 is connected to the information processing computer 3. The metal fixed mount 4 is composed by two cylinders with different diameter. The Z-axial micro motor 2 of the micro manipulator is equipped on the upper part of the fixed mount 4 and connected to the information processing computer 3. The electrochemical control system comprises a potentiostat 1, an auxiliary electrode 8, a reference electrode 9, a container 10, a working electrolyte solution 11 and so on. The disk platinum tool electrode 5 connects with the potentiostat 1 via the fixed mount 4, and thereby acts as the electrochemistry working electrode. The auxiliary electrode 8 and the reference electrode 9 are immersed into the working electrolyte solution 11. The working electrolyte solution 11 is heated and kept at a constant temperature through the fluid bath at constant temperature 13, and then injected into the container 10. Under the help of the working electrolyte solution recycling system 12, the working electrolyte solution is circulated between the container 10 and the fluid bath at constant temperature 13. The container 10 is provided on the force sensor 15 which is connected with the information processing computer 3. Moreover, both the container 10 and the force sensor 15 are equipped on the X-Y-axial (i.e. horizontal axis) micro motor 7 (not shown in Figure 1) of the manipulator. The workpiece 6 is placed in the container 10. The video monitor 14 is used to detect whether the tool electrode contacts with the workpiece or not.

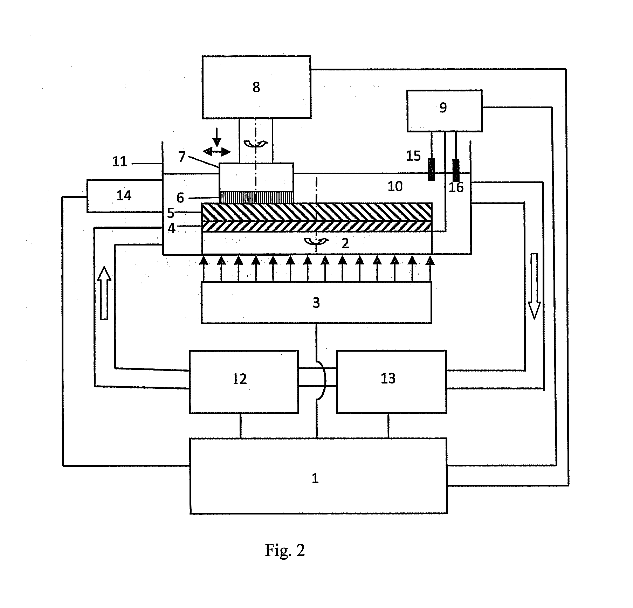

Figure 2 shows another schematic diagram of the apparatus for performing the photo/electrochemically induced, confined chemical etching method for nano-precise polishing and planarization according to the present invention. Here, the apparatus also includes a tool electrode, a photo/electrochemical reaction control system, a working electrolyte solution recycling system, a working electrolyte solution temperature controlled system, and an automated control system. As shown in Figure 2, the photo/electrochemical reaction control system includes an optical control system 3, and/or an electrochemical workstation 9. The automated control system includes an information processing computer 1, a multi-dimensional micro motor, a workbench (similar to the fixed mount in Figure 1), and a video monitor 14. The information processing computer 1 is a maincenter of the apparatus and connects with the multi-dimensional micro motor (including a tool electrode motion controller 2 and a workpiece motion controller 8, an optical control system 3, an electrochemical workstation 9, a working electrolyte solution recycling system 12, a working electrolyte solution temperature control system 13, and a video monitor 14. The information processing computer 1 is in charge of sending out commands, collecting feedback information of technical parameters, and monitoring the polishing and planarization processes. The tool electrode motion controller 2 is a super-stable rotating stage and used to fix the tool electrode 4. The working parameters of tool electrode motion controller 2 are adjustable and controlled by the information processing computer 1. The workpiece 6 is fixed on the workpiece stage 7. The workpiece stage 7 is connected with the workpiece motion controller 8, which moves vertically and/or laterally according to the commands sent out by the information processing computer 1. For an electrochemically-induced confined etching reaction, the electrochemical workstation 9, reference electrode 15, auxiliary electrode 16, the tool electrode 4 (acting as working electrode) are needed. The working electrolyte solution 10 is injected into the container 11, which is connected with the working electrolyte solution recycling system 12 and the working electrolyte solution temperature control system 13. The potential of the working electrode (i.e. the tool electrode) is controlled such that a confined etchant layer 5 is formed by the electrochemical reaction. In the case of photochemically or photoelectrochemically-induced confined chemical etching, a photocatalytic layer has to be coated on the tool electrode surface. Starting the optical control system, the exiting light irradiates on the surface of the photocatalytic layer to generate the photochemical and photoelectrochemical reaction and thereby form the radical etchant layer 5. The workpiece motion controller 8 will be activated to keep the workpiece surface contacting with the confined etchant layer until the polishing and planarization is well done. The force sensor 17 and the laser ranging probe 18 (which are not shown in Figure 2) are implanted in the workpiece stage 7 and, together with photo/electrochemical control system, are used to adjust the distance and parallelity between the tool electrode and the workpiece through the feedback parameters such as force, distant and electric current.

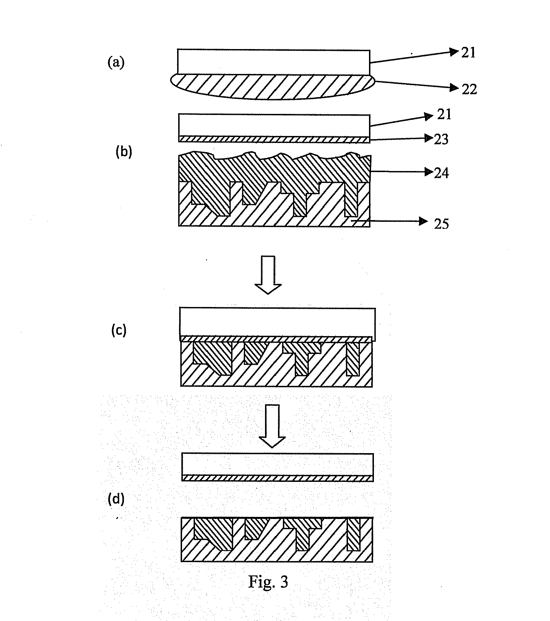

In the apparatus shown in Figures 1 and 2 for performing the photo/electrochemically induced, confined chemical etching method for nano-precise polishing and planarization according to the present invention, the principle of the polishing and planarization method are as follows: in the working electrolyte solution, a liquid layer containing etchant and/or leveling agent 22 is formed on the tool electrode (i.e. the working electrode) surface with nano-precise planeness through photo/electrochemical reaction (as shown in Figure 3a). Due to the scavenger which is added to the solution in advance can react quickly with the etchant and/or leveling agent, the life time of the etchant and/or leveling agent is dramatically shortened. That means the etchant and/or leveling agent cannot diffuse far away from the surface of tool electrode 21. The thickness of the formed "confined etchant layer" can be confined to nanometer scale (as shown in Figure 3b, where the reference number 24 is the plating layer, and the reference number 25 is the dielectric layer). The polishing and planarization will be in process once the confined etchant and leveling layer on the tool electrode surface contacts with the workpiece surface. With the etching reaction going on, the workpiece surface will separated from the confined etchant layer. So, in order to ensure that the confined etchant and leveling layer may sequentially contact with the workpiece surface and achieve the desirable etching degree, the automated control system will keep feeding the tool electrode toward the workpiece until the polishing and planarization is finished (as shown in Figure 3c). Since the confined etchant layer is very thin, i.e. has a thickness of no more than 20 nm, and has a stable concentration distribution, it keeps the planeness of the surface of tool electrode. When the etching process is done, the workpiece surface will have the same nano-precise planeness as that of the tool electrode (as shown in Figure 3d).

The photo/electrochemically-induced, confined chemical etching method for surface planarization and polishing in profile precision and surface roughness of nanometer scale as described in the present invention, can not only perform the operation of polishing and planarization on the large-scale area, but also work on the workpieces with 2-D planar, cylindrical or irregular surface.

As shown in Figure 4, the planar tool electrode 31 has a nano-precise planeness and large sizes in X-Y dimensions. The tool electrode 31 is gradually fed toward the workpiece 32 so as to perform the polishing and planarization process on the workpiece surface. The automated control system drives the tool electrode motion controller 2 to make the nanometer-thick confined etchant layer coated on the tool electrode surface approach to the workpiece surface. When the highest points on the workpiece surface touch the confined etchant layer on the workpiece surface, the chemical etching reaction occurs and the polishing and planarization process on the workpiece surface is going on. When the highest points are dissolved and separated from the etchant layer, the automated control system feeds the tool electrode to the workpiece surface. These procedures repeat until the precision requirement for the polishing and planarization is met. The reference number 33 is a planar tool electrode fabricated through ultra-precise mechanical machining.

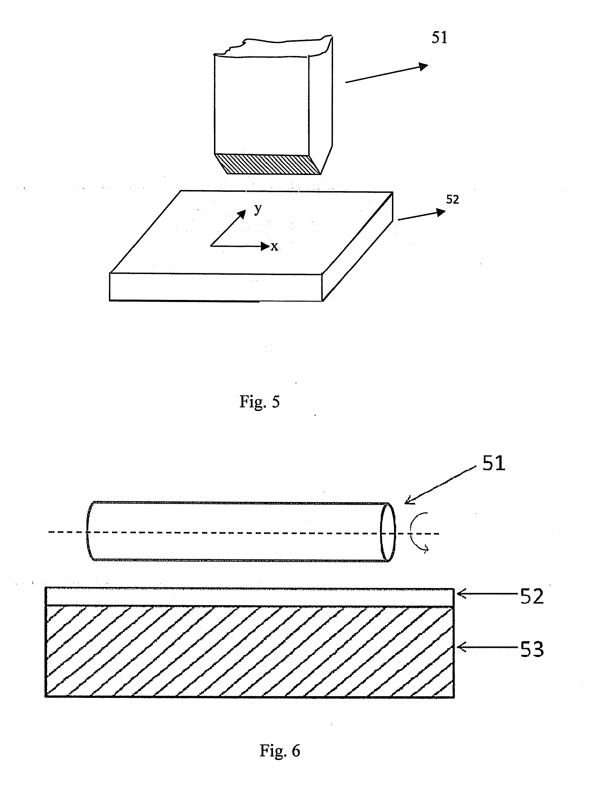

As shown in Figure 5, the linear tool electrode 41 has a nano-precise planeness and large sizes in one dimension.

Through the relative motion in X-Y directions between the tool electrode and the workpiece, the polishing and planarization process is performed on the workpiece. The automated control system drives the tool electrode motion controller 2 to make the nanometer-thick confined etchant layer approach to the surface of workpiece 42 gradually. When the highest points on the workpiece surface touch the confined etchant layer on the tool electrode, the chemical etching reaction occurs and the polishing and planarization process is going on. When the highest points are dissolved and separated from the confined etchant layer, the tool electrode or the workpiece is relatively moved in X-Y dimensions plane direction until the tool electrode has gone through the whole surface of the workpiece. These procedure repeat until the precision requirement for the polishing and planarization is met.

As shown in Figure 6, the linear tool electrode 53 has a nano-precise planeness and works on a workpiece with a cylindrical surface. Herein, the automated control system drives the tool electrode motion controller 2 to make the tool electrode having a surface coated with the nanometers-thick confined etchant layer 52 approach gradually to the surface of a rotating workpiece 51 which is rotated around the central axis. When the highest points on the workpiece surface touch the confined etchant layer, the chemical etching reaction occurs and the polishing process is going on. When the highest points are dissolved and separated from the confined etchant layer, the automated control system controls an amount of the tool electrode feeding to the workpiece until the tool electrode has gone through the whole surface of the workpiece. These procedures are repeated until the precision requirement for the polishing and planarization is met.

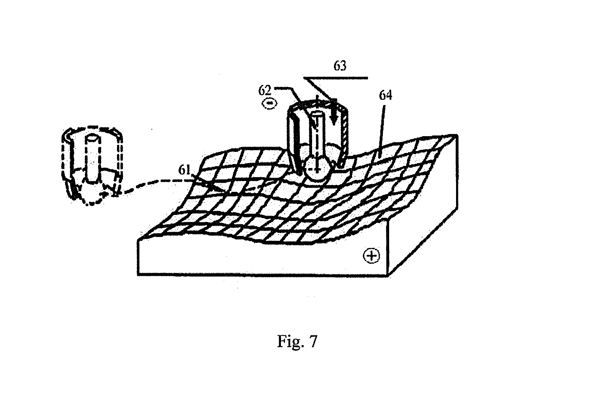

As shown in Figure 7, a milling-cutter-like tool electrode 62 with a nano-precise planeness is adopted to polish and planarize an irregular surface of a workpiece. First, the irregular surface of a workpiece is numeralizationed to program the motion trial of the tool electrode. Second, the automated control system is employed to make the confined etchant layer on the tool electrode surface contact with the workpiece surface, and then drive the tool electrode to move on the irregular surface of the workpiece according to the programmed motion trail set beforehand. In this way, the irregular surface of the workpiece is polished and smoothed. The reference number 61 is the programmed motion trail of the tool electrode. The reference number 63 is the auxiliary electrode for controlling the potential of the tool electrode. The reference number 64 is the workpiece with an irregular surface.

Next, the present invention will be more fully understood by reference to the following Examples together with other Figures. However, the Examples are only illustrative, and should not be construed as limited the scope of the invention.

## Examples

## Example 1

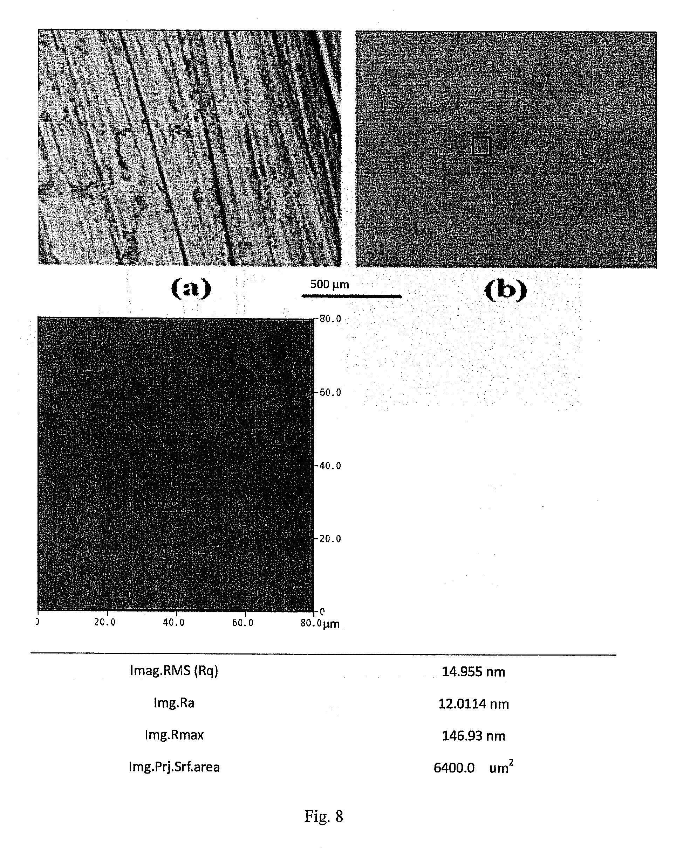

The surface of a Cu workpiece was planarized and polished using the apparatus shown in Figure 2. Processing conditions were as follows: a working electrolyte solution for circulating contained acetic acid ($0.1 mol/dm^3$, pH 5.5), benzotriazole ($2 mg/dm^3$), sodium thiosulfate ($Na_2S_2O_8$, $10 mmol/dm^3$), and N-acetylcysteine ($0.1 mol/dm^3$); the processing temperature was maintained at 25°C during the whole polishing and planarization process; when the electrochemical etching system was started, radical etchants $SO_4^{-\bullet}$ were generated by electrolysis of $Na_2S_2O_8$ at surface of Pt disk electrode as a tool electrode; N-acetylcysteine was added to the solution as a scavenger; using potentiostatic method, the potential of the tool electrode (Pt disk electrode) was kept at -0.5V vs. saturated calomel electrode (SCE) during the whole polishing and planarization process. The Pt disk tool electrode which had subjected to CMP had a surface planeness of 60 nm or more, and was fixed on the top of the tool electrode motion controller 2 as shown in Figure 2. Upon the automated control system starting, according to the parameters such as feedback current, contact force and parallelity provided by the corresponding devices such as the electric current feedback device, the force sensor and the parallel laser ranging device, the automatic operation system drove automatically the workpiece motion controller 8 and thereby make the worpiece move precisely to the Cu workpiece fixed on top of the tool electrode motion controller 2 until the confined etching layer contacted with the surface of the Cu workpiece. Thus, the process of polishing and planarization was started and the surface of the Cu workpiece was gradually removed with time going on. The automatic operation system constantly made the tool electrode feed and thereby made the chemical reaction for the polishing and planishing be continued. During the process, the workpiece was rotating at low speed (1rmp) in a ultra-steady state, and the confined etchant Layer (thickness≤50 nm) was inside the laminar layer. Therefore, the relative motion between the tool electrode and the workpiece has no impact on the planeness of the confined etchant layer surface. Processing time depended on the removal rate which was relevant to both the workpiece material and confined etching system. In the case of planarization and polishing process of Cu workpiece, feeding time of the tool electrode lasted 15 min. After that, the automatic operation system was cut off and the feeding of the tool electrode was stopped. 5 minutes later, the electrochemical system was turned off and the tool electrode is withdrawn. As shown in Fig. 8, the obtained workpiece surface was characterized by an optical microscope (Olympus BX-51, manufactured by Olympus Co.) and an atomic force microscope (Tapping Mode Nanoscope IIIa, manufactured by Digital Instrument Co.), which indicated that the surface roughness of the polished workpiece surface was 12.0 nm.

**Example 2**

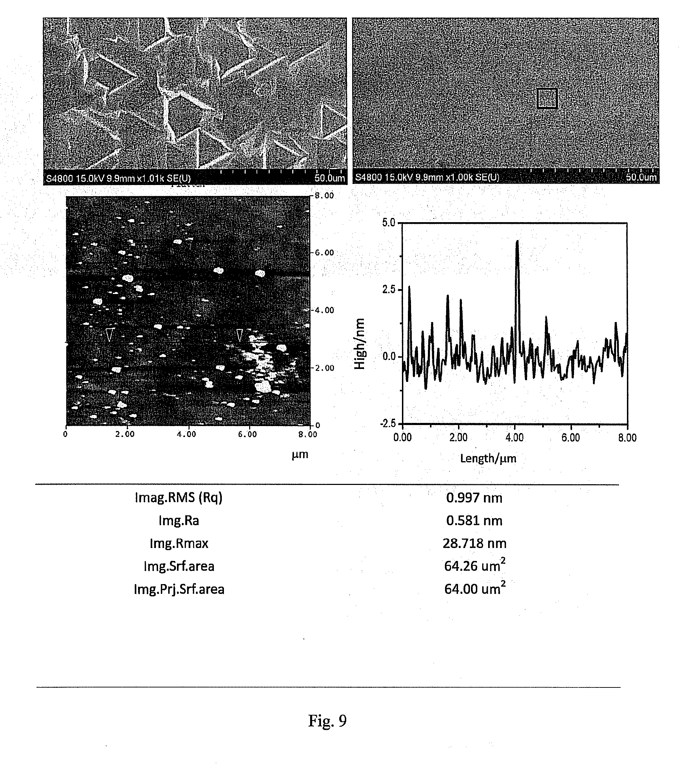

The surface of a Si workpiece was planarized and polished using the apparatus shown in Figure. 2. Processing conditions were as follows: a working electrolyte solution for circulating contained ammonium fluoride ($NH_4F$, 0.1 mol/$dm^3$), tetramethyl ammonium bromide ($(CH_4)_4NBr$, 1 mmol/$dm^3$), L-cystine (0.01 mol/$dm^3$) and sulfuric acid ($H_2SO_4$, 0.5 mol/$dm^3$); the processing temperature was maintained at 30°C during the whole polishing and planishing process; when the electrochemical etching system was started, the etchants $Br_2$ were generated by electrolyzing bromide ions $Br^-$ at the surface of the Pt disk tool electrode; L-cystine was used as the scavenger; by using potentiostatic method, the electrode potential of the Pt disk tool electrode was held at 0.9 V vs. SCE. The Pt disk tool electrode which had been subjected to CMP process, had a surface planeness of larger than 60 nm, and was fixed on the top of tool electrode motion controller 2 as shown in Figure 2. Upon the automated control system starting, according to the parameters such as feedback current, contact force and parallelity provided by the corresponding devices such as the electric current feedback device, the force sensor and the parallel laser ranging device, the automatic operation system automatically drove the workpiece motion controller 8 such that the workpiece was precisely move to the tool electrode which was fixed on the top of the tool electrode motion controller 2 until the confined etching layer (having a confined thickness of <20 nm) coated on the tool electrode surface contacted with the Si surface. Thus, the process of polishing and planarization was started and the Si surface would be gradually removed with time going on. The automatic operation system kept feeding the tool electrode so as to ensure the polishing and planarization processing to be continued. In the case of planarization and polishing process of Si workpiece, the time of feeding the tool electrode lasted 10 min. After that, the automatic operation system was cut off, and further 3 minutes later, the electrochemical system was turned off and the tool electrode was withdrawn. As shown in Fig. 9, the obtained workpiece surface was characterized by scanning electron microscope (FESEM LEO 1530, manufactured by LEO Co.) and atomic microscope (Tapping Mode Nanoscope IIIa, manufactured by Digital Instrument Co.), which indicated the surface roughness of the polished workpiece surface was 0.6 nm.

**Example 3**

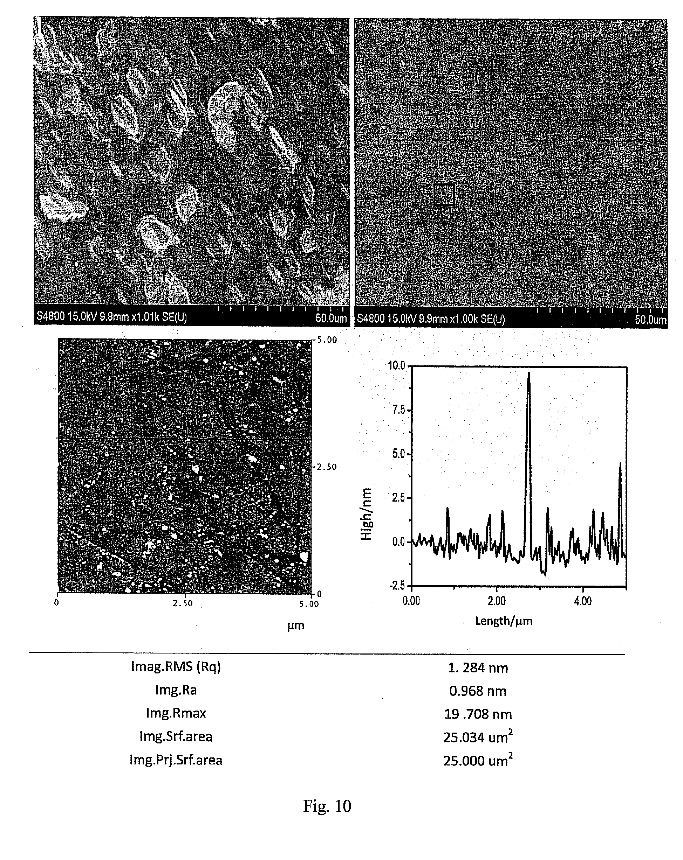

The surface of a gallium arsenide (GaAs) workpiece was planarized and polished using the apparatus shown in Fig. 2. Processing conditions are as follows: a working electrolyte solution for circulating contained hydrogen bromide HBr (10 mol/$dm^3$), L-cystine (10 mmol/$dm^3$) and $H_2SO_4$ (0.5 mol/$dm^3$); the processing temperature was maintained at 20°C during the whole polishing process; when the electrochemical etching system was started, the etchants $Br_2$ were generated by electrolyzing bromide ion $Br^-$ at the surface of the Pt disk tool electrode; L-cystine was used as the scavenger; In the process of polishing and planishing, by using potentiostatic method, the electrode potential of the Pt disk tool electrode was held at 0.9 V vs. SCE. The Pt disk tool electrode which had subjected to CMP had a surface planeness of larger than 60nm, and was fixed on the top of tool electrode motion controller 2 as shown in Figure 2. Upon the automated control system starting, according to the parameters such as feedback current, contact force and parallelity provided by the corresponding devices such as the electric current feedback device, the force sensor and the laser ranging device, the automatic operation system drove automatically the workpiece motion controller 8 and thereby make the worpiece move precisely to the tool electrode fixed on the top of the tool electrode motion controller 2 until the confined etching layer on the tool electrode surface contacted with the Si surface. Thus, the process of polishing and planarization was started and the Si surface would be gradually removed with time going on. The automatic operation system kept feeding the tool electrode so as to ensure the chemical reaction for the polishing and planarization processing to be continued. In the case of planarization and polishing process in this example, the time of feeding the tool electrode lasted 8 min. After that, the automatic operation system was cut off and the feeding of tool electrode was stopped. Further 2 minutes later, the electrochemical system was turned off and the tool electrode was withdrawn. As shown in Fig. 10, the obtained workpiece surface was characterized by scanning electron microscope (FESEM LEO 1530, manufactured by LEO Co.) and atomic microscope (Tapping Mode Nanoscope IIIa, manufactured by Digital Instrument Co.), which indicated that the surface roughness of the polished surface was 1.0 nm.

**Example 4**

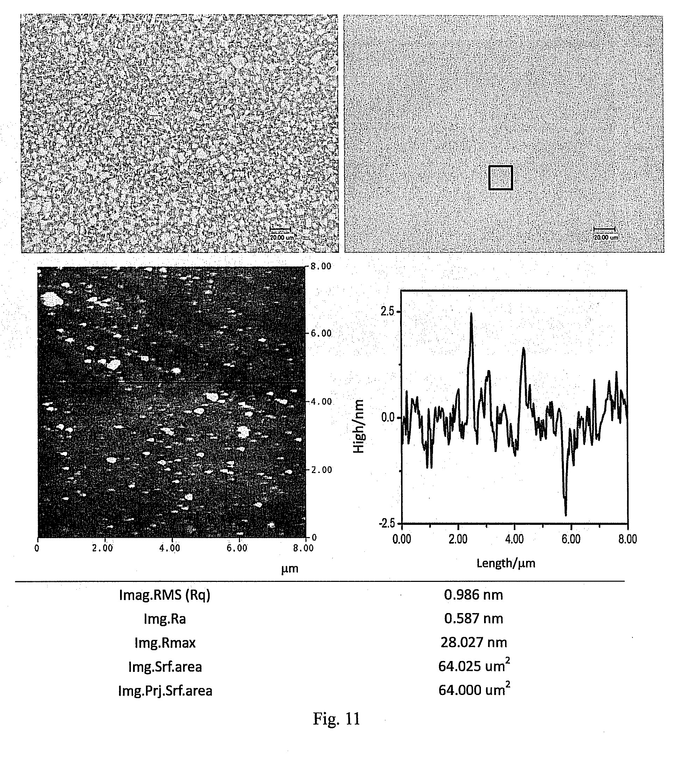

The $SiO_2$ glass surface of a workpiece was planarized and polished using the apparatus shown in Fig. 2. Processing conditions were as follows: a working electrolyte solution for circulating contained ammonium fluoride $NH_4F$ (0.1 mol/$dm^3$), ammonia ($NH_4OH$, pH 12), sodium nitrite ($NaNO_2$, 10 mmol/$dm^3$); the processing temperature was maintained at 30°C during the whole polishing and planishing process; when the electrochemical etching system was started, the etchants $H^+$ were generated by electrolyzing $NaNO_2^-$ at the surface of the Pt disk tool electrode, thus, a strong acidic etching layer was formed on the surface of the Pt disk tool electrode; in the strong acidic environment, $SiO_2$ formed a complex with $F^-$ and thereby was removed; $OH^-$ in the etching solution which is provided by $NH_4OH$ was used as the scavenger, and make a thickness of the confined etchant layer be confined to a thickness of 20 nm or less; during the process for polishing and planishing, by using potentiostatic method, the electrode potential of the tool electrode (i.e. the Pt disk tool electrode) was held at 0.9 V vs. SCE. The Pt disk tool electrode which had been subjected to CMP process, had a surface planeness of larger than 60nm, and was fixed on the top of tool electrode motion controller 2 as shown in Figure 2. Upon the automated control system starting, according to the parameters such as feedback current, contact force and parallelity provided by the corresponding devices such as the electric current feedback device, the force sensor and the parallel laser ranging device, the automatic operation system automatically drove the workpiece motion controller 8 such that the workpiece was precisely move to the tool electrode which was fixed on the top of the tool electrode motion controller 2. Thus, the process of polishing and planarization was started and the surface of the $SiO_2$ glass workpiece would be gradually removed with time going on. The automated control system kept feeding the tool electrode so as to ensure the polishing and planarization processing to be continued. In the case of planarization and polishing process, the time of feeding the tool electrode lasted 30 min. After that, the automatic operation system was cut off and the feeding of tool electrode was stopped. Further 10 minutes later, the electrochemical system was turned off and the tool electrode was withdrawn. As shown in Fig. 11, the obtained workpiece surface was characterized by optical microscope (Olympus BX-51, manufactured by Olympus Co.) and atomic microscope (Tapping Mode Nanoscope IIIa, manufactured by Digital Instrument Co.), which indicated that the surface roughness of the polished surface was 0.6 nm.

**Examples 5 to 32**

Processing steps in examples 5 to 13 were similar to those in example 2, processing steps in examples 14 to 22 were similar to those in example 1, and processing steps in examples 23 to 31 were similar to those in example 4, except that the components of the workinging electrolyte solutions, of the scavengers, and contents thereof. The specific components and contents thereof may be seen in tables 1 to 3. Etching results can be characterized using high-powered optical microscope (Olympus BX-51, manufactured by Olympus Co.) and atomic microscope (Tapping Mode Nanoscope IIIa, manufactured by Digital Instrument Co). The surface roughness Ra was obtained by analysis the scanning results from atomic force microscope (Tapping Mode Nanoscope IIIa, manufactured by Digital Instrument Co).

Table 1

| Example No. | Polishing solution for Si etching | | | Scavenger | surface roughness Ra(nm) |
| --- | --- | --- | --- | --- | --- |
| | $(CH_4)_4NBr$ $(mol/dm^3)$ | $H_2SO_4$ $(mol/dm^3)$ | $NH_4F$ $(mol/dm^3)$ | L-Cystine $(mol/dm^3)$ | |
| 5 | 0.001 | 0.5 | 1 | 0.001 | 1.9 |
| 6 | 0.001 | 0.5 | 1 | 0.01 | 1.2 |
| 7 | 0.001 | 0.5 | 1 | 0.1 | 0.6 |
| 8 | 0.005 | 0.1 | 0.1 | 0.1 | 1.3 |
| 9 | 0.005 | 0.1 | 0.1 | 0.3 | 0.7 |
| 10 | 0.005 | 0.1 | 0.1 | 0.5 | 0.5 |
| 11 | 0.005 | 0.5 | 1 | 0.1 | 1.1 |
| 12 | 0.005 | 0.5 | 1 | 0.3 | 0.6 |
| 13 | 0.005 | 0.5 | 1 | 0.5 | 0.5 |

As shown in Table 1, the nano-precision photo/electrochemical planarization and polishing methods according to the present invention can be applied in the polishing of Si, and result in remarkable effect. Moreover, surface roughness Ra of the resulted workpiece was 2.0 nm or less.

Table 2

| Example No. | Polishing solution for Cu etching | | | Scavenger | surface roughness Ra(nm) |
|---|---|---|---|---|---|
| | $K_2S_2O_8$ (mol/dm$^3$) | $CH_3CO_2H$ -$CH_3CO_2Na$ (pH 5.5, mol/dm$^3$) | Benzotriazole (mol/dm$^3$) | N-acetylcysteine (mol/dm$^3$) | |
| 14 | 0.01 | 0.1 | 0.1 | 0.01 | 24.3 |
| 15 | 0.01 | 0.1 | 0.1 | 0.1 | 15.4 |
| 16 | 0.01 | 0.1 | 0.1 | 0.5 | 8.3 |
| 17 | 0.001 | 0.5 | 1 | 0.1 | 14.7 |
| 18 | 0.001 | 0.5 | 0.1 | 0.3 | 11.6 |
| 19 | 0.001 | 0.1 | 2 | 0.1 | 8.5 |
| 20 | 0.005 | 0.1 | 1 | 0.3 | 15.3 |
| 21 | 0.005 | 0.1 | 0.1 | 0.3 | 9.8 |
| 22 | 0.005 | 0.5 | 1 | 0.1 | 7.2 |

As seen in Table 2, the nano-precision photo/electrochemical planarization and polishing methods according to the present invention can be applied in the polishing of Cu workpiece, and result in remarkable effect. Moreover, surface roughness Ra of the resulted workpiece was 25 nm or less.

Table 3

| Example No. | Polishing solution for SiO$_2$ etching | | | Scavenger | surface roughness Ra(nm) |
|---|---|---|---|---|---|
| | KNO$_2$ (mol/dm$^3$) | Dodecyl sulphonic acid (mol/dm$^3$) | NH$_4$F (mol/dm$^3$) | NH$_4$OH (mol/dm$^3$) | |
| 23 | 0.005 | 0.005 | 1 | 0.01 | 1.1 |
| 24 | 0.005 | 0.005 | 0.1 | 0.01 | 0.8 |
| 25 | 0.005 | 0.005 | 0.01 | 0.01 | 1.3 |
| 26 | 0.01 | 0.001 | 1 | 1 | 0.9 |
| 27 | 0.01 | 0.001 | 0.1 | 1 | 1.2 |
| 28 | 0.01 | 0.001 | 0.01 | 1 | 1.3 |
| 29 | 0.01 | 0.001 | 1 | 0.5 | 0.9 |
| 30 | 0.01 | 0.001 | 0.1 | 0.5 | 0.9 |
| 31 | 0.01 | 0.001 | 0.01 | 0.5 | 1.1 |

As seen in Table 3, the nano-precision photo/electrochemical planarization and polishing methods according to the present invention can be applied in the polishing of SiO$_2$ workpiece, and result in more remarkable effect. Moreover, surface roughness Ra of the resulted workpiece was 1.5 nm or less.

Table 4

| Example No. | Working condition for photochemical planarization and polishing Cu | | | | surface roughness Ra(nm) |
|---|---|---|---|---|---|
| | Catalyst TiO$_2$ | Thickness of TiO$_2$ film (nm) | Light source | pH | |
| 32 | Nanotube (on the tool electrode) | 100 | 500W Xenon lamp | 4 | 10.7 |

Remark: pH was adjustable by using 0.01mol/L HClO$_4$ and 0.01mol/L NaOH, and 0.01 mol/L NaClO4 was used as the supporting electrolyte.

**Industrial applicability**

The planarization and polishing method and an apparatus therefor the same according to the present invention may provide a surface of the workpiece with profile precision and surface roughness of nanometer scale (i.e nano-precision). In addition, the present invention has more advantages over CMP technology due to no surface and subsurface mechanical damage, no residual stress, no metal ion contaminations, and having controllable end-point of the polishing and planarization process. Therefore, the present invention is especially suitable to be applied in the field of the industrial semiconductor materials, ultra large scale integrated circuit, Micro Electromechanical System (MEMS), Micro Opto-Electro-Mechanical Systems, modem precision optical device, aerospace engine blades, and *etc..*

**Claims**

1.    A photo/electrochemically-induced confined chemical etching method for a surface planarization and polishing in nano-precision, comprising:

    through electrochemical, photochemical or photoelectrochemical means, an etchant being generated on a surface of a tool electrode which has a nanometer-sized planeness;
    the generated etchant reacting with a scavenger contained in an working electrolyte solution, or decaying itself in the working electrolyte solution, such that a confined etchant liquid layer is generated on the tool electrode surface and has a confined thickness of nanoscale; and
    by a chemical reaction between the etchant contained in the confined etchant liquid layer and a surface of a workpiece, the surface of the workpiece being polished or planarized to a nanometer scaled profile precision and surface roughness, thereby, realizing the planarization and polishing in nano-precision for the workpiece.

2.    The photo/electrochemically-induced confined chemical etching method for a surface planarization and polishing in nano-precision according to claim 1, wherein a concentration ratio of precursor which generates the etchant or leveling agent to the scavenger usually is in a range of from 10:1 to 1:100 if the scavenger is existed.

3.    The photo/electrochemically-induced confined chemical etching method for a surface planarization and polishing in nano-precision according to claim 1, wherein the chemical reaction between the etchant and the workpiece are at least one selected from the group consisting of
    means of controlling the pH of the confined etchant liquid layer to promote the concentration of strong acidic species in the confined etchant liquid layer such that the workpiece is reacted to produce soluble salt;
    means of generating a strong oxidative etchant which reacts directly with the workpiece to produce a soluble compound;
    means of forming an oxidative material which oxidizes the workpiece surface to an oxide, and then the oxide is dissolved by acidic or alkali species in the working electrolyte solution;
    means of adding an additive or surfactant to the working electrolyte solution, which is complex with metal ions of the workpiece through complex reaction; and
    means of generating strong oxidants in the confined etchant liquid layer, together adding complexing agents to the confined etchant lquid layer so as to promote solubility of the resultant product.

4.    The photo/electrochemically-induced confined chemical etching method for a surface planarization and polishing in nano-precision according to claim 3, wherein the scavenger is selected from the group of consisting of disulfide bond compounds, ferrocene and its derivatives, persulfate salts, nitrites, sulfites, thiosulfates, ascorbic acid, cystine and sorbitols.

5.    The photo/electrochemically-induced confined chemical etching method for a surface planarization and polishing in nano-precision according to claim 1, wherein the working electrolyte solution further contains at least one selected from the group consisting of surfactants, supporting electrolytes, pH buffers and the mixtures thereof.

6.    The photo/electrochemically-induced confined chemical etching method for a surface planarization and polishing in nano-precision according to claim 1, wherein the tool electrode with nanometer planeness is manufactured by at least one selected form the group consisting of methods (1) to (6):

(1) a method of fabricating a tool electrode with nano-planeness of platinum, gold, iridium, tungsten or other metal though the ultra-precision machining;

(2) a method of depositing a metal or semiconductor on a substrate with an atomic planeness through various processes for forming film, or growing a metal or semiconductor on the substrate through crystal epitaxial growth technology to make the substrate conductive;

(3) a method of fabricating a single-crystal electrode having a surface of nano-planeness formed of platinum, gold, iridium and other metals through accurately cooling or drawing of the corresponding metal melt;

(4) a method of fabricating a electrode having a nanometer-precise surface planeness by polishing and planishing polycrystal or single crystal metal electrode through CMP technology together with an electrolytic process;

(5) a method of using a nanometer planeness surface formed by liquid metal or alloys spontaneously; and

(6) a method for photocatalytical or photoelectrocatalytical tool electrode, which comprising a step of using an insulating quartz optical material or conductive ITO or FTO optical glass as a substrate, and a step of covering the substrate with a layer of $TiO_2$, $ZnO$, $WO_3$, $Fe_2O_3$, $CdSe$ or the composite photocatalysts thereof through surface modification, electrochemical deposition in situ or chemical vapor deposition.

7. The photo/electrochemically-induced confined chemical etching method for a surface planarization and polishing in nano-precision according to claim 1, further comprising: controlling the distance between the tool electrode and the workpiece less than the thickness of the confined etchant layer, and/or controlling the relative motion between the tool electrode and the workpiece so as to improve the profile precision the workpiece surface and lower the surface roughness of the workpiece surface.

8. The photo/electrochemically-induced confined chemical etching method for a surface planarization and polishing in nano-precision according to in claim 7, wherein in the case of the tool electrode being a planar tool electrode, the profile precision the workpiece surface can be improved and the surface roughness the workpiece surface can be lowered by means of making the tool electrode or the workpiece rotate in a plane while being parallel swing.

9. The photo/electrochemically-induced confined chemical etching method for a surface planarization and polishing in nano-precision according to claim 1, wherein the method further includes a step of adjusting the distance and parallelity between the tool electrode and the workpiece.

10. An apparatus for the photo/electrochemically-induced confined chemical etching method for a surface planarization and polishing in nano-precision, wherein the apparatus comprises a tool electrode, a photo/electrochemical reaction control system, a working electrolyte solution recycling system, a working electrolyte solution temperature control system, and an automated control system; and wherein the tool electrode is a tool electrode having a surface of nano-planeness;

the photo/electrochemical reaction control system is provided with a potentiostat, an optic control system, a photo/electrochemical working electrode, an auxiliary electrode, a reference electrode, a working electrolyte solution and a container for the working electrolyte solution, and the tool electrode functions as the photo/electrochemical working electrode and connects with the potentiostat and/or the optic control system, and the photo/electrochemical working electrode, the auxiliary electrode and reference electrode are immersed in the container in which the working electrolyte solution is contained, and the workpiece is further contained;

the working electrolyte solution recycling system is used to recycle the working electrolyte solution in the electrochemical reaction system and its instrumental control system;

the working electrolyte solution temperature control system is used to keep the temperature of the working electrolyte solution in the electrochemical reaction system and its instrumental control system at a constant temperature;

the automated computer-controlled system is provided with a fixed mount, a multi-dimension micro manipulator, a video monitor, a force sensor, a parallel laser ranging device, an electrolytic current feedback device and an information processing computer, wherein a lower part of the fixed mount is used to fix the tool electrode, and an upper part of the fixed mount is connected to the Z-axial micro motor of the multi-dimension micro manipulator in the automated computer-controlled system which connects with the information processing computer; the X-Y-axial micro motors of the multi-dimension micro-manipulator are employed as a workbench to support the container; the video monitor is used to monitor an approaching process of the tool electrode to the workpiece; the current feedback device is used to monitor or measure the electrical current flowing through the tool electrode surface; the force sensor is used to detect whether the tool electrode touches the workpiece or not; the parallel laser ranging device is used to detect the distance between the tool electrode surface and the workpiece surface; according to the collected parameters such as the feedback current provided by the electrical current feedback device, the contact force provided by the force sensor, and the distance between the two surfaces provide by the parallel laser ranging device, the information processing computer sends commands to the Z-axial micro motor and the X-Y-axial micro motors of the multi-dimension micro-manipulator to adjust the distance and parallelity between the tool electrode surface and the workpiece surface;

the working electrolyte solution contains precursors of the etchant and/or leveling agent, and the precursors of the etchant and/or leveling agent can produce the etchant and leveling agents on the surface of the tool electrode through photo/electrochemical reaction, wherein if the produced etchant and leveling agents cannot decay spontaneously, the working electrolyte solution needs to further contain scavenger which reacts with the etchant and/or leveling agent contained in the etchant liquid layer and compacts the etchant liquid layer to a namometer-scaled thickness.

**11.** The apparatus for the photo/electrochemically-induced confined chemical etching method for a surface planarization and polishing in nano-precision according to claim 10, wherein the apparatus adjusts the thickness of the confined etchant and/or leveling agent liquid layer by tuning the potential of the photo/electrochemical reaction system, wavelength and intensity of incident light, photocatalytical layer parameter, and the formulation, temperature and circulation of the working electrolyte solution.

Fig. 1

Fig. 2

(a)

(b)

(c)

(d)

Fig. 3

Fig. 4

51

52

y

x

Fig. 5

51

52

53

Fig. 6

Fig. 7

(a)    500 µm    (b)

| Imag.RMS (Rq) | 14.955 nm |
| Img.Ra | 12.0114 nm |
| Img.Rmax | 146.93 nm |
| Img.Prj.Srf.area | 6400.0 um$^2$ |

Fig. 8

| Imag.RMS (Rq) | 0.997 nm |
| Img.Ra | 0.581 nm |
| Img.Rmax | 28.718 nm |
| Img.Srf.area | 64.26 um$^2$ |
| Img.Prj.Srf.area | 64.00 um$^2$ |

Fig. 9

| Imag.RMS (Rq) | 1. 284 nm |
| Img.Ra | 0.968 nm |
| Img.Rmax | 19 .708 nm |
| Img.Srf.area | 25.034 um$^2$ |
| Img.Prj.Srf.area | 25.000 um$^2$ |

Fig. 10

| Imag.RMS (Rq) | 0.986 nm |
| Img.Ra | 0.587 nm |
| Img.Rmax | 28.027 nm |
| Img.Srf.area | 64.025 um$^2$ |
| Img.Prj.Srf.area | 64.000 um$^2$ |

Fig. 11

# INTERNATIONAL SEARCH REPORT

International application No.

PCT/CN2011/076700

### A. CLASSIFICATION OF SUBJECT MATTER

see extra sheet

According to International Patent Classification (IPC) or to both national classification and IPC

### B. FIELDS SEARCHED

Minimum documentation searched (classification system followed by classification symbols)

IPC:C25F 3/-, H01L 21/-

Documentation searched other than minimum documentation to the extent that such documents are included in the fields searched

Electronic data base consulted during the international search (name of data base and, where practicable, search terms used)

CNPAT, CNKI, WPI, EPODOC, polish+, electropolish+, planar+, etch+, scaveng+, nano+, accuracy, precision, restraint+, electrochem+, photoelectric+, driv+, rotat+, loop+, circulat+, cycle, confined etchant layer

### C. DOCUMENTS CONSIDERED TO BE RELEVANT

| Category* | Citation of document, with indication, where appropriate, of the relevant passages | Relevant to claim No. |
|---|---|---|
| P,X | CN101880907A (UNIV XIAMEN), 10 November 2010 (10.11.2010), see its claims 1-10, paragraph [0030]-[0033] of its description, examples of its description | 1-11 |
| X | CN1425805A (UNIV XIAMEN), 25 June 2003 (25.06.2003), see its claims 1-12, figure 1 of its description | 1，3,7，9 |
| Y | | 2,4-6，8，10-11 |
| Y | CN1569610A (UNIV XIAMEN), 26 January 2005 (26.01.2005), see its claims 1-4, examples of its description | 2，4-6，8，10-11 |

☒ Further documents are listed in the continuation of Box C.　☒ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim (S) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&"document member of the same patent family |

| Date of the actual completion of the international search | Date of mailing of the international search report |
|---|---|
| 01 September 2011 (01.09.2011) | **29 Sep. 2011 (29.09.2011)** |
| Name and mailing address of the ISA/CN The State Intellectual Property Office, the P.R.China 6 Xitucheng Rd., Jimen Bridge, Haidian District, Beijing, China 100088 Facsimile No. 86-10-62019451 | Authorized officer **LI, Chunzhu** Telephone No. (86-10)62084392 |

Form PCT/ISA /210 (second sheet) (July 2009)

**EP 2 592 178 A1**

<table>
<tr><td colspan="2"><b>INTERNATIONAL SEARCH REPORT</b></td><td>International application No.<br><br>PCT/CN2011/076700</td></tr>
</table>

C (Continuation).     DOCUMENTS CONSIDERED TO BE RELEVANT

| Category* | Citation of document, with indication, where appropriate, of the relevant passages | Relevant to claim No. |
|---|---|---|
| A | US20040238492A1 (LSI LOGIC CORP ETAL.), 02 December 2004 (02.12.2004), see the whole document | 1-11 |
| A | CN100564241C (UNIV XIAMEN), 02 December 2009 (02.12.2009), see the whole document | 1-11 |
| A | US7531079B1 (NOVELLUS SYSTEMS INC), 12 May 2009 (12.05.2009), see the whole document | 1-11 |

Form PCT/ISA /210 (continuation of second sheet ) (July 2009)

## INTERNATIONAL SEARCH REPORT
Information on patent family members

| International application No. |
| --- |
| PCT/CN2011/076700 |

| Patent Documents referred in the Report | Publication Date | Patent Family | Publication Date |
| --- | --- | --- | --- |
| CN101880907A | 10.11.2010 | none | |
| CN1425805A | 25.06.2003 | CN100406618C | 30.07.2008 |
| CN1569610A | 26.01.2005 | CN1274582C | 13.09.2006 |
| US2004238492A1 | 02.12.2004 | US7029591B2 | 18.04.2006 |
| CN100564241C | 02.12.2009 | CN101234744A | 06.08.2008 |
| US7531079B1 | 12.05.2009 | none | |

Form PCT/ISA /210 (patent family annex) (July 2009)

# INTERNATIONAL SEARCH REPORT

International application No.

PCT/CN2011/076700

**Continuation of second sheet :**

**A CLASSIFICATION OF SUBJECT MATTER**

C25F 3/12 (2006.01) i
H01L 21/3063 (2006.01)i

According to International Patent Classification (IPC) or to both national classification and IPC

Form PCT/ISA /210 (extra sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• CN ZL03101271X